# EUROPÄISCHE PATENTSCHRIFT

(11) **EP 1 144 720 B1**
(45) Veröffentlichungstag und Bekanntmachung des Hinweises auf die Patenterteilung: **08.10.2003**
(21) Anmeldenummer: 99967885.7
(22) Anmeldetag: 17.12.1999
(51) Int. Cl.: C23C 16/40

(54) **VERFAHREN ZUR HERSTELLUNG EINER WÄRMEDÄMMSCHICHT**
METHOD FOR PRODUCING A THERMAL BARRIER COATING
PROCEDE DE PRODUCTION D'UNE COUCHE DE CALORIFUGEAGE

(30) Priorität: 18.12.1998 DE 19858701
(43) Veröffentlichungstag der Anmeldung: 17.10.2001
(73) Patentinhaber: MTU Aero Engines GmbH, 80995 München (DE)
(72) Erfinder: STOLLE, Ralf, D-85221 Dachau (DE); COSACK, Thomas, D-86949 Windach (DE); SCHWEITZER, Klaus, D-82343 Niederpöcking (DE); PULVER, Michael, D-31542 Bad Nenndorf (DE); Prof. Dr. WAHL, Georg, D-38302 Wolfenbüttel (DE)
(74) Vertreter: Einsele, Rolf W.
(86) Internationale Anmeldenummer: DE9904018
(87) Internationale Veröffentlichungsnummer: WO00037711

(56) Entgegenhaltungen:
- KIM J S ET AL: "DEPOSITION AND STRUCTURAL CHARACTERIZATION OF ZRO2 AND YTTRIA-STABILIZED ZRO2 FILMS BY CHEMICAL VAPOR DEPOSITION" THIN SOLID FILMS,CH,ELSEVIER-SEQUOIA S.A. LAUSANNE, Bd. 254, Nr. 1/02, 1. Januar 1995 (1995-01-01), Seiten 33-38, XP000481492 ISSN: 0040-6090
- CAO C -B ET AL: "RESEARCH ON YSZ THIN FILMS PREPARED BY PLASMA-CVD PROCESS" THIN SOLID FILMS,CH,ELSEVIER-SEQUOIA S.A. LAUSANNE, Bd. 249, Nr. 2, 15. September 1994 (1994-09-15), Seiten 163-167, XP000464945 ISSN: 0040-6090
- MASANOBU AIZAWA ET AL: "PREPARATION OF ZRO2-Y2O3 FILMS BY CVD USING B-DIKETONE METAL CHELATES" JOURNAL OF THE CERAMIC SOCIETY OF JAPAN, INTERNATIONAL EDITION,JP,FUJI TECHNOLOGY PRESS, TOKYO, Bd. 101, Nr. 3, 1. März 1993 (1993-03-01), Seiten 283-286, XP000381420 ISSN: 0912-9200
- BERTRAND G ET AL: "Zirconia coatings realized by microwave plasma-enhanced chemical vapor deposition" THIN SOLID FILMS,CH,ELSEVIER-SEQUOIA S.A. LAUSANNE, Bd. 292, Nr. 1, 5. Januar 1997 (1997-01-05), Seiten 241-246, XP004060876 ISSN: 0040-6090

## Beschreibung

Die Erfindung betrifft ein Verfahren zur Herstellung einer Wärmedämmschicht für heißgasbeaufschlagte Bauteile von Verbrennungskraftmaschinen, wobei die Wärmedämmschicht eine kolumnare Struktur aufweist.

Zur Herstellung von Wärmedämmschichten sind sog. Aufdampfverfahren (EB-PVD) bekannt, bei denen die auf dem metallischen Bauteil abzuscheidenden Substanzen, wie z.B. Zirkoniumoxid, in einer Hochvakuumumgebung mit einem Elektronenstrahl verdampft werden. Infolge der starken Energieeinbringung bildet sich eine dünne, schmelzflüssige Zone, aus der die Substanzen verdampfen und sich in einer Kondensationsreaktion an der Oberfläche des Bauteils ablagern. Die auf diese Weise hergestellten Schichten besitzen eine dehnungstolerante, kolumnare Struktur, welche die im Thermowechselbetrieb auftretenden Spannungen besser aufnehmen kann und zu einer verlängerten Lebensdauer führt.

Als nachteilig erweisen sich bei diesen Verfahren die extrem hohen Anlagenkosten für die Elektronenstrahlkanone, für die Erzeugung des Hochvakuums, für die Vakuumkammer und für die Partialdrucksteuerung. Des weiteren lassen sich die nicht direkt sichtbaren Flächen des Bauteils während des Beschichtungszyklus nicht oder nur unzureichend beschichten.

Aus der EP 0 055 459 A1 ist ein Verfahren zur Herstellung von Oxidschichten mittels chemischer Gasphasenabscheidung (CVD) bekannt, bei dem von Diketonen abgeleitete Komplexe, wie z.B. Acetylacetonat-Komplexe, zur Oxidation der in den Komplexen enthaltenen Metallen mit Wasserdampf gemischt und auf einem Substrat abgeschieden werden. Das Substrat wird dabei in verschiedenen Anwendungen auf Temperaturen zwischen 350 °C und 800 °C erhitzt. Die Dicken der abgeschiedenen Schichten liegen im Bereich zwischen 3,6 und 34 µm. Der Einsatz von Wasserdampf als Trägergas wird als zwingend herausgestellt, da bei Sauerstoff weder eine Reproduzierbarkeit noch eine Abscheidung erzielt werden kann.

Die WO 94/21841 offenbart ein Flamm-CVD-Verfahren zum Aufbringen von anorganischen Schichten auf Substrate, bei dem Mischoxide, wie Yttrium- stabilisiertes Zirkonoxid, bei Flammtemperaturen von 300 °C bis 2800 °C und deutlich über Umgebungsdruck liegenden Drücken abgeschieden werden. Die Ausgangssubstanzen der Beschichtungsgase werden in die Flamme geleitet und können bei einem solchen Flamm-CVD-Verfahren nicht unter einer definierten Temperaturführung erwärmt und zum Substrat transportiert werden.

Das Dokument KIM J S ET AL: ,DEPOSITION AND STRUCTURAL CHARACTERIZATION OF ZRO2 AND YTTRIA-STABILIZED ZRO2 FILMS BY CHEMICAL VAPOR DEPOSITION" THIN SOLID FILMS, CH, ELSEVIER-SEQUOIA S.A. LAUSANNE, Bd. 254, Nr. 1/02, 1. Januar 1995 (1995-01-01), Seiten 33-38, XP000481492 ISSN: 0040-6090, berichtet über die Herstellung von yttriumstabilisierten Zirkoniumschichten (YSZ). Ein Anwendungsbereich ist die Herstellung von dielektrischen Puffer- bzw. Barriereschichten zwischen Siliziumsubstraten und hochtemperatursupraleitenden Oxidfilmen. Im einzelnen werden Zirkoniumtetrakisacetylacatonat (Zr(acac)₄) und Yttriumtrisdipivaloylmethanat (Y(dpm)₃) = Yttriumtris (2,2,6,6-tetramethyl-3,5-heptandionat) als Ausgangssubstanzen eingesetzt. Die Ausgangssubstanzen werden durch Erwärmen verdampft (Zr(acac)₄ auf 160°C und Y(dpm)₃ auf 100 - 150°C) und auf dem induktiv geheizten Siliziumsubstrat abgeschieden. Die Trägergase enthalten Argon und Sauerstoff. Der Systemdruck während der Abscheidung beträgt ungefähr 300 Pa. Für yttriumstabilisierte Zirkoniumschichten berichtet dieses Dokument über Abscheidungstemperaturen von 620 - 710°C.

Das Dokument CAO, C-B ET AL: ,RESEARCH ON YSZ THIN FILMS PREPARED BY PLASMA-CVD PROCESS' THIN SOLID FILMS, CH, ELSEVIER-SEQUOIA S.A. LAUSANNE, Bd. 249, Nr. 2, 15. September 1994 (1994-09-15), Seiten 163 bis 167, XP000464945 ISSN: 0040-6090, berichtet über die Herstellung von yttriumstabilisierten Zirkoniumschichten auf Substraten, wie Glas, Silizium oder porösen Aluminiumoxidkeramiken. Die YSZ-Schicht dient als Sauerstoffsensor in Feststoffelektrolyt-Brennstoffzellen. Als Ausgangsstoffe dienen Zr(dpm)₄ und Y(dpm)₃, die thermisch verdampft werden. Das Substrat hat eine Temperatur von 450 bis 550°C. Als Trägergas dient ein Gemisch aus Ar und O₂, der Systemdruck beträt 400 Pa. Es werden unter anderem YSZ-Filme mit über 7 mol% Y₂O₃ erzeugt.

Das Dokument MASANOBU AIZAWA ET AL: ,PREPARATION OF ZRO2-Y2O3 FILMS BY CVD USING B-DIKETONE METAL CHELATES' JOURNAL OF THE CERAMIC SOCIETY OF JAPAN, INTERNATIONAL EDITION, JP, FUJI TECHNOLOGY PRESS, TOKYO, Bd. 101, Nr. 3, 1. März 1993 (1993-03-01), Seiten 283-286, XP000381420 ISSN: 0912-9200, berichtet über ein Verfahren, bei dem yttriumstabilisierte Zirkoniumschichten unter anderem aus den thermisch verdampften Ausgangsstoffen Zr(dpm)₄ und Y(dpm)₃ abgeschieden werden. Die YSZ-Schicht dient ebenfalls als Sauerstoffsensor in Feststoffelektrolyt-Brennstoffzellen. Als Substrat dient Quarzglas. Die Abscheidetemperatur liegt bei 600 - 1000°C, der Gesamtdruck bei 1,33 kPa (10 torr). Das Trägergas besteht aus einem Gemisch aus Ar und O₂. Es wurden YSZ-Filme mit ca. 3 - 15 mol% Y₂O₃ erzeugt (vgl. Abschnitt 2. "Experiment" und Figuren 4 und 5).

Das Dokument BERTRAND G ET AL:, Zirconia coatings realized by microwave plasma-enhanced chemical vapor deposition' THIN SOLID FILMS, CH, ELSEVIER-SEQUOIA S.A. LAUSANNE, Bd. 292, Nr. 1, 5. Januar 1997 (1997-01-05), Seiten 241 - 246, XP004060876 ISSN: 0040-6090, berichtet über die Herstellung von Zirkonoxid-Wärmedämmschichten auf Turbinenschaufeln, also heißgasbeaufschlagten Bauteilen von Verbrennungskraftmaschinen. Die Zirkonoxidschichten weisen eine kolumnare Struktur auf. Die Schichtdicken liegen bei 100 - 500 µm (vgl. Figur 3 und Tabelle 2). Die Abscheidung erfolgt durch plasmaunterstützte Zersetzung von ZrCl₄.

Bei bekannten Verfahren zur Herstellung von Wärmedämmschichten mittels chemischer Gasphasenabscheidung (CVD) konnten bisher lediglich schlecht haftende, sehr dünne Schichten mit niedriger Abscheiderate ohne kolumnare Struktur hergestellt werden, die zudem unerwünschte Kohlenstoffverunreinigungen in größeren Mengen enthalten. Der Auswahl der Ausgangssubstanzen kommt im Hinblick auf den technischen Einsatz eine besondere Bedeutung zu, da diese zum einen nicht zu teuer sein dürfen und zum anderen in ausreichenden Mengen verfügbar sein müssen.

Das der vorliegenden Erfindung zugrunde liegende Problem besteht darin, ein Verfahren zur Herstellung einer Wärmedämmschicht der eingangs beschriebenen Gattung zu schaffen, bei dem eine Wärmedämmschicht mit guten Schichteigenschaften und einer kolumnaren Struktur möglichst kostengünstig hergestellt wird.

Die Lösung dieses Problems ist erfindungsgemäß darin zu sehen, dass als Ausgangssubstanzen Acetylacetonate von Zirkonium und wenigstens einem Stabilisierungselement aus dem Bereich der Erdalkali- oder Seltenerdmetalle bereitgestellt werden, die Ausgangssubstanzen durch Erwärmen auf maximal 250°C unter Bildung der Beschichtungsgase verdampft werden, die Beschichtungsgase in einem auf maximal 250°C erwärmten Einlasssystem zu dem zu beschichtenden Bauteil transportiert werden, dessen Oberfläche auf eine Abscheidetemperatur zwischen 300°C und 1100°C erwärmt wird, und dort bei einem Prozessdruck von 0,5 bis 50 mbar unter Abscheidung einer Wärmedämmschicht mit einer Schichtdicke zwischen 25 µm und 1000 µm zersetzt werden. Dabei erweist sich als vorteilhaft, dass sich mit dem auf dem Prinzip der chemischen Gasphasenabscheidung (CVD) basierenden Verfahren Zirkon- und z.B. Yttriumoxid enthaltende Wärmedämmschichten mit ausreichend großer Schichtdicke herstellen lassen. Zudem besitzen die so hergestellten Wärmedämmschichten eine geeignete Kristallstruktur und Morphologie sowie geforderte Schichteigenschaften. Die Schichten sind im Hinblick auf ihre Beständigkeit im Thermowechselversuch mit den nach dem EB-PVD hergestellten Verfahren vergleichbar. Ein weiterer Vorteil besteht darin, dass anders als bei den sog. Aufdampfverfahren (EB-PVD) aufgrund der Streukraft des Prozesses auch die nicht unmittelbar sichtbaren Oberflächen des zu beschichtenden Bauteils beschichtet werden können.

Bevorzugt werden als Stabilisierungselement aus dem Bereich der Erdalkali- oder Seltenerdmetalle Yttrium, Lanthan, Calcium, Magnesium oder Cer bereitgestellt, da diese im Hinblick auf die Prozeßkosten nicht zu teuer und darüber hinaus für den technischen Einsatz in ausreichenden Mengen verfügbar sind.

Weitere Ausgestaltungen der Erfindung sind in den Unteransprüchen beschrieben.

Im folgenden wird die Erfindung anhand von Ausführungsbeispielen unter Bezugnahme auf eine Zeichnung näher erläutert. Es zeigen:
- Fig. 1: eine schematische Schnittansicht durch eine gemäß einem Ausführungsbeispiel des erfindungsgemäßen Verfahrens hergestellte Wärmedämmschicht und
- Fig. 2: eine mikroskopische Aufnahme einer gemäß einem Ausführungsbeispiel des erfindungsgemäßen Verfahrens hergestellten Wärmedämmschicht, in der eine kolumnare Struktur zu erkennen ist.

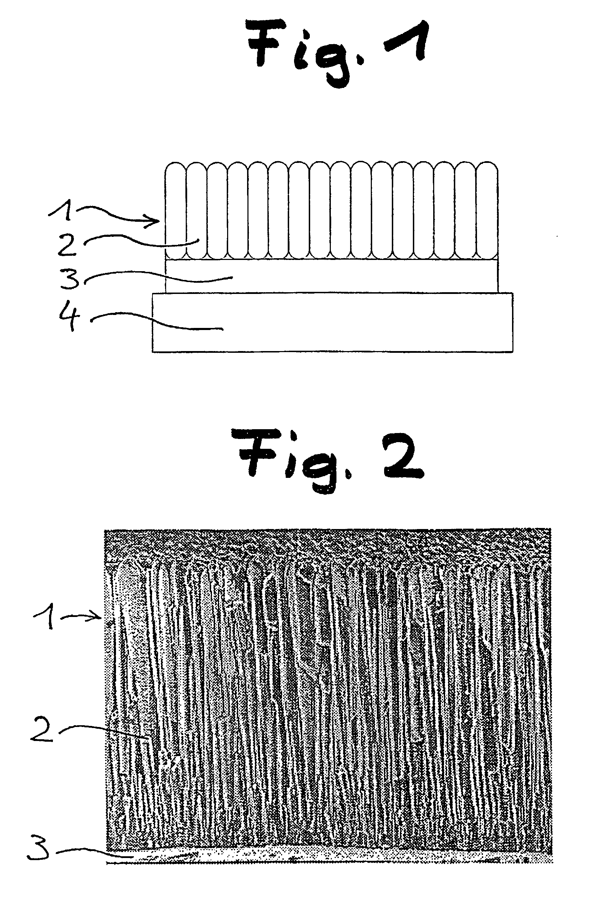

Fig. 1 zeigt eine im ganzen mit 1 bezeichnete Wärmedämmschicht mit einer kolumnaren Struktur 2, d.h. einer sog. Stengelkristallstruktur, die auf einem mit einer Haftschicht 3 versehenen Substrat 4 abgeschieden ist. Das Substrat 4 ist bei dem vorliegenden Ausführungsbeispiel eine im Betrieb heißgasumströmte Oberfläche einer metallischen Laufschaufel von einer Gasturbine. Alternativ können mit dem Verfahren z.B. auch Leitschaufeln von Gasturbinen oder andere heißgasbeaufschlagte Teile von Verbrennungskraftmaschinen beschichtet werden.

Bei dem vorliegenden Ausführungsbeispiel des Verfahrens zur Herstellung einer Wärmedämmschicht mittels Gasphasenabscheidung (CVD) wird zunächst eine Haftschicht 3 mit einem herkömmlichen Verfahren auf die heißgasumströmte Oberfläche der Laufschaufel 4 aufgebracht. Die Haftschicht 3 ist bevorzugt heißgaskorrosionsbeständig und kann z.B. eine Aluminium-Diffusionsschicht, eine Platin/Aluminium-Diffusionsschicht oder eine sog. MCrAIY-Auflageschicht sein.

Anschließend werden die Ausgangssubstanzen für die Abscheidung der Wärmedämmschicht 1 mittels chemischer Gasphasenabscheidung (CVD) bereitgestellt.

Hierfür werden Acetylacetonatokomplexe von Zirkonium und Yttrium ausgewählt, die jeweils in Pulverform vorliegen und zur Ausbildung der gewünschten Schichtstöchiometrie im benötigten Verhältnis gemischt werden. Alternativ können die Ausgangssubstanzen auch getrennt verdampft und in der Gasphase gemischt werden. Die Ausgangssubstanzen werden durch Erwärmen auf maximal 250 °C unter Bildung der Beschichtungsgase verdampft bzw. in die Gasphase überführt und zu den zu beschichtenden Laufschaufeln 4 transportiert. Das Transportieren erfolgt mittels geeigneter Trägergase, wie z.B. Sauerstoff oder einem Gemisch aus Sauerstoff und Argon.

Zudem werden die zu beschichtenden Oberflächen der Laufschaufeln 4 mit einer geeigneten Wärmequelle auf eine Abscheidetemperatur zwischen 300 °C und 1100 °C erwärmt. Dabei ist gewährleistet, daß die Beschichtungsgase auf ihrem Strömungsweg zu den zu beschichtenden Laufschaufeln 4 nicht auf über 250 °C erwärmt werden. Dieses erfolgt z.B. durch Einsatz eines auf maximal 250 °C erwärmten und unter Berücksichtigung der Wärmequellen für die Bauteile bzw. Laufschaufeln 4 angeordneten Einlaßsystems, durch welches die Beschichtungsgase und das Trägergas zu der zu beschichtenden Oberfläche der Laufschaufel 4 transportiert werden.

In der Nähe der auf die Abscheidetemperatur erwärmten Oberfläche der Laufschaufeln 4 läßt sich eine solche Erwärmung der Beschichtungsgase infolge der Wärmestrahlung unter Umständen nicht vollständig vermeiden. Um die bei erhöhten Temperaturen möglichen Gasphasenreaktionen der Beschichtungsgase zu unterbinden, erfolgt die Herstellung bzw. Abscheidung der Wärmedämmschicht 1 bei vergleichsweise niedrigen Prozeßdrücken von 0,5 bis 50 mbar und mithin einer geringen Verweilzeit in den heißen Zonen um die auf Abscheidetemperatur erwärmten Laufschaufeln 4 herum. Zur Erzielung des für die vorliegende Gasphasenabscheidung erforderlichen, niedrigen Prozeßdrucks wird das Verfahren in einem geschlossenen Rezipienten durchgeführt, an den eine Pumpe angeschlossen ist.

Beim Auftreffen der Beschichtungsgase auf die auf Abscheidetemperatur erwärmten Oberflächen der Laufschaufeln 4 erfolgt die chemische Zersetzung der Ausgangssubstanzen und die Abscheidung von mit Yttriumoxid stabilisiertem Zirkonoxid unter Bildung der Wärmedämmschicht 1 und gasförmiger Nebenprodukte. Aufgrund der hohen Abscheidetemperaturen erfolgt eine vollständige Zersetzung. Es treten kaum Kohlenstoffverunreinigungen auf. Darüber hinaus weist die abgeschiedene Wärmedämmschicht 1 eine dehnungstolerante, kolumnare Struktur 2 bzw. eine sog. Stengelkristallstruktur auf, die sich vorteilhaft auf die Thermowechselbeständigkeit und die Lebensdauer der Wärmedämmschicht 1 auswirkt. Durch Ausnutzung der aerodynamischen Strömungsverhältnisse werden bei dem vorliegenden Verfahren infolge der Streuung nicht nur die direkt sichtbaren bzw. angeströmten Oberflächen der Laufschaufeln 4, sondern alle mit den Beschichtungsgasen angeströmten und erwärmten Oberflächen beschichtet. Die Nebenprodukte werden in einem nachgeschalteten Pyrolyseofen zersetzt und anschließend gefiltert und entsorgt

Zur Verbesserung der Gleichmäßigkeit der Beschichtung können die Laufschaufeln 4 in dem Rezipienten bewegt werden. Je nach Steuerung des Verfahrens lassen sich Wärmedämmschichten 1 mit einer Schichtdicke von etwa 25 bis 1000 µm auf den Oberflächen der Laufschaufeln 4 abscheiden, wobei die Schichtdicke im allgemeinen zwischen 75 und 250 µm liegt. Im Vergleich zu Laufschaufeln werden bei Leitschaufeln von Gasturbinen häufig Wärmedämmschichten 1 mit höheren Schichtdicken abgeschieden. Zur Bildung der Wärmedämmschichten 1 wird vorliegend mit 7 - 9 Gew.-% Yttriumoxid teilstabilisiertes Zirkonoxid abgeschieden. Das Verfahren läßt sich für alle heißgasbeaufschlagte Teile einer Gasturbine oder anderer Verbrennungskraftmaschinen anwenden.

## Patentansprüche

1. Verfahren zur Herstellung einer Wärmedämmschicht für heißgasbeaufschlagte Bauteile von Verbrennungskraftmaschinen, wobei die Wärmedämmschicht eine kolumnare Struktur aufweist, **dadurch gekennzeichnet, dass** als Ausgangssubstanzen Acetylacetonate von Zirkonium und wenigstens einem Stabilisierungselement aus dem Bereich der Erdalkali- oder Seltenerdmetalle bereitgestellt werden, die Ausgangssubstanzen durch Erwärmen auf maximal 250 °C unter der Bildung der Beschichtungsgase verdampft werden, die Beschichtungsgase in einem auf maximal 250 °C erwärmten Einlasssystem zu dem beschichtenden Bauteil (4), dessen Oberfläche auf eine Abscheidetemperatur zwischen 300 °C und 1100 °C erwärmt wird, transportiert und dort bei einem Prozessdruck von 0,5 bis 50 mbar unter Abscheidung einer Wärmedämmschicht (1) mit einer Schichtdicke zwischen 25 µm und 1000 µm zersetzt werden.

2. Verfahren nach Anspruch 1, **dadurch gekennzeichnet, dass** als Stabilisierungselement aus dem Bereich der Erdalkali- oder Seltenerdmetalle Yttrium, Lanthan, Calcium, Magnesium oder Cer bereitgestellt wird.

3. Verfahren nach Anspruch 1 oder 2, **dadurch gekennzeichnet, dass** die Beschichtungsgase mit einem Trägergas gemischt werden.

4. Verfahren nach einem oder mehreren der vorhergehenden Ansprüche, **dadurch gekennzeichnet, dass** als Trägergas Sauerstoff oder ein Gemisch aus Sauerstoff und Argon bereitgestellt wird.

5. Verfahren nach einem oder mehreren der vorhergehenden Ansprüche, **dadurch gekennzeichnet, dass** die Beschichtungsgase bzw. die Beschichtungsgase und das Trägergas in dem Einlasssystem zu dem zu beschichtenden Bauteil (4) transportiert werden.

6. Verfahren nach einem oder mehreren der vorhergehenden Ansprüche, **dadurch gekennzeichnet, dass** die Ausgangssubstanzen als Pulver bereitgestellt werden.

7. Verfahren nach einem oder mehreren der vorhergehenden Ansprüche, **dadurch gekennzeichnet, dass** 7 bis 9 Gew.-% Yttriumoxid teilstabilisiertes Zirkonoxid abgeschieden wird.

8. Verfahren nach einem oder mehreren der vorhergehenden Ansprüche, **dadurch gekennzeichnet, dass** die Wärmedämmschicht (1) mit einer Schichtdicke zwischen 75 und 250 µm auf dem zu beschichtenden Bauteil (4) abgeschieden wird.

## Claims

1. A process for producing a heat-insulating layer for components of internal combustion engines exposed to hot gas, the heat-insulating layer having a columnar structure,
**characterised in that**
acetlyacetonates of zirconium and at least one stabilising element drawn from the alkaline earth metals or rare earth elements are provided as the starting substances, these starting substances are vaporised by heating to a maximum of 250°C to form the coating gases, the coating gases are transported in a inlet system heated to a maximum of 250°C to the component (4) to be coated, the surface of said component (4) being heated to a deposition temperature of between 300°C and 1100°C, where they are decomposed at a process pressure of 0.5 to 50 mbar and deposit a heat-insulating layer (1) with a layer thickness of between 25 µm and 1000 µm.

2. A process in accordance with claim 1,
**characterised in that**
yttrium, lanthanum, calcium, magnesium or cerium drawn from the alkaline earth metals or rare earth elements are provided as the stabilising element.

3. A process in accordance with claim 1 or 2,
**characterised in that**
the coating gases are mixed with a carrier gas.

4. A process in accordance with one or more of the preceding claims,
**characterised in that**
oxygen or a mixture of oxygen and argon is provided as the carrier gas.

5. A process in accordance with one or more of the preceding claims,
**characterised in that**
the coating gases or the coating gases and a carrier gas are transported to the component (4) to be coated in the inlet system.

6. A process in accordance with one or more of the preceding claims,
**characterised in that**
the starting substances are provided in powder form.

7. A process in accordance with one or more of the preceding claims,
**characterised in that**
7 to 9 % by weight yttrium oxide partially stabilised zirconium oxide is deposited.

8. A process in accordance with one or more of the preceding claims,
**characterised in that**
the heat-insulating layer (1) with a layer thickness of between 75 and 250 µm is deposited on the component (4) to be coated.

## Revendications

1. Procédé de production d'une couche à calorifugeage pour les pièces constitutives de machines à combustion interne sollicitées par des gaz brûlants, la couche à calorifugeage présentant une structure en colonne, **caractérisé en ce qu'**on dispose d'acétylacétonate de zirconium et d'au moins un élément stabilisant de la famille des alcalinoterreux ou des terres rares comme substances de départ, les substances de départ étant vaporisées par chauffage à 250°C maximum avec formation des gaz de revêtement, ces gaz de revêtement étant transportés dans un système d'admission à 250°C maximum jusqu'à la pièce à enduire (4), dont la surface est chauffée à une température de dépôt comprise entre 300 et 1 100°C et y étant décomposés à une pression de procédé comprise entre 0,5 et 50 mbar avec dépôt d'une couche calorifugeage (1) d'une épaisseur comprise entre 25 et 1 000 µm.

2. Procédé selon la revendication 1, **caractérisé en ce que** l'yttrium, le lanthane, le calcium, le magnésium ou le cérium est mis à disposition comme élément stabilisant de la famille des alcalinoterreux ou des terres rares.

3. Procédé selon la revendication 1 ou 2, **caractérisé en ce que** les gaz de revêtement sont mélangés avec un gaz vecteur.

4. Procédé selon une ou plusieurs des revendications précédentes, **caractérisé en ce que** de l'oxygène ou un mélange d'oxygène et d'argon est mis à disposition comme gaz vecteur.

5. Procédé selon une ou plusieurs des revendications précédentes, **caractérisé en ce que** les gaz de revêtement et/ou les gaz de revêtement et le gaz vecteur, sont transportés jusqu'à la pièce à recouvrir (4) dans le système d'admission.

6. Procédé selon une ou plusieurs des revendications précédentes, **caractérisé en ce que** les substances de départ sont mises à disposition sous forme de poudre.

7. Procédé selon une ou plusieurs des revendications précédentes, **caractérisé en ce que** de l'oxyde de zirconium partiellement stabilisé à 7 à 9% en poids d'oxyde d'yttrium est déposé.

8. , Procédé selon une ou plusieurs des revendications précédentes, **caractérisé en ce que** la couche à calorifugeage (1) est déposée sur la pièce à recouvrir (4) sur une épaisseur comprise entre 75 et 250 µm.
